# EUROPEAN PATENT SPECIFICATION

(11) **EP 1 926 150 B1**
(45) Date of publication and mention of the grant of the patent: **14.04.2010**
(21) Application number: 07121107.2
(22) Date of filing: 20.11.2007
(51) Int. Cl.: H01L 31/18, B23K 26/06

(54) **Multiple station laser ablation apparatus**
Mehrstationen-Vorrichtung zur Laserablation
Dispositif multiposte d'ablation par laser

(30) Priority: 21.11.2006 US 562383
(43) Date of publication of application: 28.05.2008
(73) Proprietor: Palo Alto Research Center Incorporated, Palo Alto, California 94304 (US)
(72) Inventor: Curry, Douglas N., San Mateo, CA 94402 (US)
(74) Representative: Grünecker, Kinkeldey, Stockmair & Schwanhäusser Anwaltssozietät

(56) References cited:
- EP-A- 1 145 797
- WO-A-97/21253
- WO-A-97/48519
- JP-A- 2 187 291
- US-A- 5 569 399
- US-A- 5 981 902
- US-A1- 2002 060 208
- US-A1- 2003 095 175

## Description

### FIELD OF THE INVENTION

This invention relates to the conversion of light irradiation to electrical energy, more particularly, to methods and tools for producing photovoltaic devices (solar cells) that convert solar energy to electrical energy.

### BACKGROUND OF THE INVENTION

Solar cells are typically photovoltaic devices that convert sunlight directly into electricity. Solar cells typically include a semiconductor (e.g., silicon) that absorbs light irradiation (e.g., sunlight) in a way that creates free electrons, which in turn are caused to flow in the presence of a built-in field to create direct current (DC) power. The DC power generated by several PV cells may be collected on a grid placed on the cell. Current from multiple PV cells is then combined by series and parallel combinations into higher currents and voltages. The DC power thus collected may then be sent over wires, often many dozens or even hundreds of wires.

The state of the art for metallizing silicon solar cells for terrestrial deployment is screen printing. Screen printing has been used for decades, but as cell manufacturers look to improve cell efficiency and lower cost by going to thinner wafers, the screen printing process is becoming a limitation. The screen printers run at a rate of about 1800 wafers per hour and the screens last about 5000 wafers. The failure mode often involves screen and wafer breakage. This means that the tools go down every couple of hours, and require frequent operator intervention. Moreover, the printed features are limited to about 100 microns, and the material set is limited largely to silver and aluminum metallizations.

The desired but largely unavailable features in a wafer-processing tool for making solar cells are as follows: (a) never breaks a wafer - e.g. non contact; (b) one second processing time (i.e., 3600 wafers/hour); (c) large process window; and (d) 24/7 operation other than scheduled maintenance less than one time per week. The desired but largely unavailable features in a low-cost metal semiconductor contact for solar cells are as follows: (a) Minimal contact area - to avoid surface recombination; (b) Shallow contact depth - to avoid shunting or otherwise damaging the cell's pn junction; (c) Low contact resistance to lightly doped silicon; and (d) High aspect metal features (for front contacts to avoid grid shading while providing low resistance to current flow).

Given the above set of desired features, the tool set for the next generation solar cell processing line is expected to look very different from screen printing. Since screen printing is an inherently low resolution contact method, it is unlikely to satisfy all of the criteria listed above. Solar cell fabrication is an inherently simple process with tremendous cost constraints. All of the printing that is done on most solar cells is directed at contacting and metallizing the emitter and base portions of the cell. The metallization process can be described in three steps, (1) opening a contact through the surface passivation, (2) making an electrical contact to the underlying silicon along with a robust mechanical contact to the solar cell and (3) providing a conducting path away from the contact.

Currently, the silver pastes used by the solar industry consist of a mixture of silver particles and a glass frit in an organic vehicle. Upon heating, the organic vehicle decomposes and the glass frit softens and then dissolves the surface passivation layer creating a pathway for silicon to reach the silver. The surface passivation, which may also serve as an anti-reflection coating, is an essential part of the cell that needs to cover the cell in all but the electrical contact areas. The glass frit approach to opening contacts has the advantage that no separate process step is needed to open the passivation. The paste mixture is screened onto the wafer, and when the wafer is fired, a multitude of random point contacts are made under the silver pattern. Moreover, the upper portions of the paste densify into a metal thick film that carries current from the cell. These films form the gridlines on the wafer's front-side, and the base contact on the wafer's backside. The silver is also a surface to which the tabs that connect to adjacent cells can be soldered. A disadvantage of the frit paste approach is that the emitter (sun-exposed surface) must be heavily doped otherwise the silver cannot make good electrical contact to the silicon. The heavy doping kills the minority carrier lifetime in the top portion of the cell. This limits the blue response of the cell as well as its overall efficiency.

In the conventional screen printing approach to metallizing solar cells, a squeegee presses a paste through a mesh with an emulsion pattern that is held over the wafer. Feature placement accuracy is limited by factors such as screen warpage and stretching. The feature size is limited by the feature sizes of the screen and the rheology of the paste. Feature sizes below 100 microns are difficult to achieve, and as wafers become larger, accurate feature placement and registration becomes more difficult. Because it is difficult to precisely register one screen printed pattern with another screen printed pattern, most solar cell processes avoid registering multiple process steps through methods like the one described above in which contacts are both opened and metallized as the glass frit in the silver paste dissolves the nitride passivation. This method has numerous drawbacks however. Already mentioned is the heavy doping required for the emitter. Another problem is a narrow process window. The thermal cycle that fires the gridline must also burn through the silicon nitride to provide electrical contact between the silicon and the silver without allowing the silver to shunt or otherwise damage the junction. This severely limits the process time and the temperature window to a temperature band on the order of 10 degrees C about a set point of 850C and a process time of on the order of 30 seconds. However, if one can form a contact opening and register metallization of the desired type, a lower contact resistance can be achieved with a wider process margin.

The most common photovoltaic device cell design in production today is the front surface contact cell, which includes a set of gridlines on the front surface of the substrate that make contact with the underlying cell's emitter. Ever since the first silicon solar cell was fabricated over 50 years ago, it has been a popular sport to estimate the highest achievable conversion efficiency of such a cell. At one terrestrial sun, this so-called limit efficiency is now firmly established at about 29% (see Richard M. Swanson, "APPROACHING THE 29% LIMIT EFFICIENCY OF SILICON SOLAR CELLS" 31s IEEE Photovoltaic Specialists Conference 2005). Laboratory cells have reached 25%. Only recently have commercial cells achieved a level of 20% efficiency. One successful approach to making photovoltaic devices with greater than 20% efficiency has been the development of backside contact cells. Backside contact cells utilize localized contacts that are distributed throughout p and n regions formed on the backside surface of the device wafer (i.e., the side facing away from the sun) to collect current from the cell. Small contact openings finely distributed on the wafer not only limit recombination but also reduce resistive losses by serving to limit the distance carriers must travel in the relatively less conductive semiconductor in order to reach the better conducting metal lines.

One route to further improvement is to reduce the effect of carrier recombination at the metal semiconductor interface in the localized contacts. This can be achieved by limiting the metal-semiconductor contact area to only that which is needed to extract current. Unfortunately, the contact sizes that are readily produced by low-cost manufacturing methods, such a screen printing, are larger than needed. Screen printing is capable of producing features that are on the order of 100 microns in size. However, features on the order of 10 microns or smaller can suffice for extracting current. For a given density of holes, such size reduction will reduce the total metal-semiconductor interface area, and its associated carrier recombination, by a factor of 100.

The continual drive to lower the manufacturing cost of solar power makes it preferable to eliminate as many processing steps as possible from the cell fabrication sequence. As described in US Published Application No. US2004 0200520 A1 by SunPower Corporation, typically, the current openings are formed by first depositing a resist mask onto the wafer, dipping the wafer into an etchant, such a hydrofluoric acid to etch through the oxide passivation on the wafer, rinsing the wafer, drying the wafer, stripping off the resist mask, rinsing the wafer and drying the wafer.

What is needed is a method and processing system for producing photovoltaic devices (solar cells) that overcomes the deficiencies of the conventional approach described above by both reducing the manufacturing costs and complexity, and improving the operating efficiency of the resulting photovoltaic devices.

Document JP 02 187 291 discloses a laser ablation apparatus comprising a plurality of laser working beams generated from a same laser source, wherein a plurality of working points can be pierced of the sometime in a rectilinear alignment. Document US 598 1901 discloses a laser texturing apparatus comprising a substrate rotating means.

### SUMMARY OF THE INVENTION

It is the object of the present invention to improve an apparatus for micro-machining of target objects. This object is achieved by providing a multi-station laser ablation apparatus according to claim 1 and a system for producing a plurality of photovoltaic devices according to claim 10. Embodiments of the invention are set forth in the dependent claims.

### BRIEF DESCRIPTION OF THE DRAWINGS

These and other features, aspects and advantages of the present invention will become better understood with regard to the following description, appended claims, and accompanying drawings, where:
Fig. 1 is a perspective view showing a multiple station laser ablation apparatus according to an embodiment of the present invention;
Fig. 2 is a perspective view showing an exemplary laser scanning mechanism utilized in the laser ablation apparatus of Fig. 1;
Fig. 3 is a flow diagram showing a simplified method for producing photovoltaic devices according to an embodiment of the present invention;
Fig. 4 is a simplified diagram showing an assembly for producing photovoltaic devices utilizing the system of Fig. 1 according to another embodiment of the present invention;
Figs. 5(A) and 5(B) are top plan and side elevation views depicting a simplified semiconductor substrate prior to laser ablation;
Fig. 6 is a top plan view showing the multiple station laser ablation apparatus of Fig. 1 during operation;
Figs. 7(A) and 7(B) are plan and partial perspective views showing a semiconductor substrate after laser ablation;
Fig. 8 is a plan view showing a semiconductor substrate during direct-write metallization according to another aspect of the present invention;
Fig. 9 is a partial perspective view showing the semiconductor substrate of Fig. 8 after direct-write metallization;
Fig. 10 is a perspective view showing a multiple station laser ablation apparatus according to an alternative embodiment of the present invention; and
Fig. 11 is a top plan view showing a multiple station laser ablation apparatus according to another alternative embodiment of the present invention.

### DETAILED DESCRIPTION OF THE DRAWINGS

The present invention relates to an improvement in photovoltaic devices (e.g., solar cells) that can be used, for example, to convert solar power into electrical energy. The following description is presented to enable one of ordinary skill in the art to make and use the invention as provided in the context of a particular application and its requirements. As used herein, directional terms such as "upper", "lower", "side", "front", "rear", are intended to provide relative positions for purposes of description, and are not intended to designate an absolute frame of reference. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

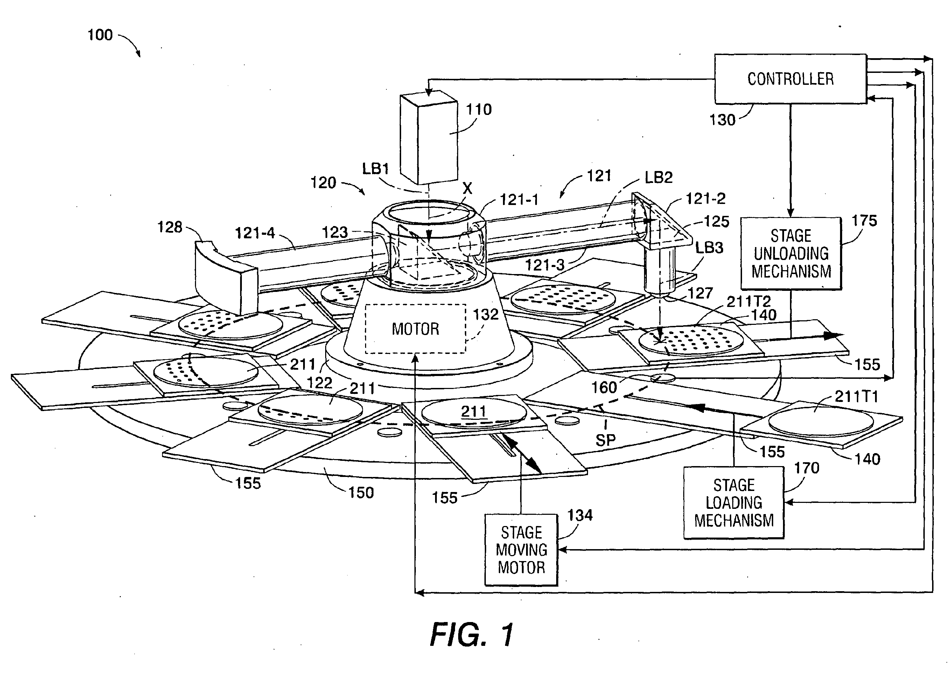

Fig. 1 shows a multi-station laser ablation apparatus 100 according to an exemplary embodiment of the present invention. Laser ablation apparatus 100 includes a centrally positioned laser device 100 that transmits input laser beam pulses LB1 along a central axis X, a novel laser scanning mechanism 120 that is disposed to redirect the laser beam pulses onto a circular scan path SP (indicated by heavy dashed line), and a circular platform 150 including multiple processing stations 155 that are circumferentially disposed around central axis X and respectively position a photovoltaic device wafer (target object) 211 such that scan path SP intersects multiple wafers 211.

As described below, multi-station laser ablation apparatus 100 is utilized in one embodiment to perform non-contact micro-machining (i.e., laser ablation patterning of a passivation layer) in the production of solar cells, thus avoiding the problems associated with conventional screen patterning techniques. The contact openings generated by laser-based ablation devices are substantially smaller than the minimum openings produced by conventional screen printing processes. The laser-based ablation device also facilitates removal of the passivation without significantly altering the thickness or doping profile of the underlying silicon layer. In a specific embodiment, light source 110 is a femto-second laser, which facilitates shallow ablation with a minimum of debris. A particular advantage of femto-second laser pulses is that the power density can be sufficiently high that the electric field of the optical pulse becomes comparable to the inter-atomic fields of the atoms in the material. This becomes important in the present application because it is desired to ablate the passivation without disturbing the underlying semiconductor. The passivation is typically Silicon Nitride having a thickness of 800 angstroms, and as such has a large band gap and it typically transparent. Ordinarily, light would pass through the passivation and become adsorbed by the underlying semiconductor. With sufficiently high power density, the interaction of light with matter alters such that even ordinarily transparent materials become adsorbing. Multiple photons can be adsorbed on a site in the material before the excited electronic states can relax. By adsorbing energy in the dielectric passivation, the surface layer can be selectively ablated. For a photovoltaic device with a shallow layer of dopants, this selective surface ablation is advantageous. The n-type emitter of a typical screen printed solar cell for example is only about 200 to 300 nm thick. If an ablated contact opening in the passivation were to extend through the emitter, then the metallization could form a shunt to the p-type material below the emitter, ruining the device.

Although the present invention is described herein with specific reference to the production of photovoltaic devices, those skilled in the art will recognize that multi-station laser ablation apparatus 100 may be utilized to process many different target objects. Therefore, unless otherwise specified in the appended claims, the present invention is not intended to be limited by the specific embodiment described herein.

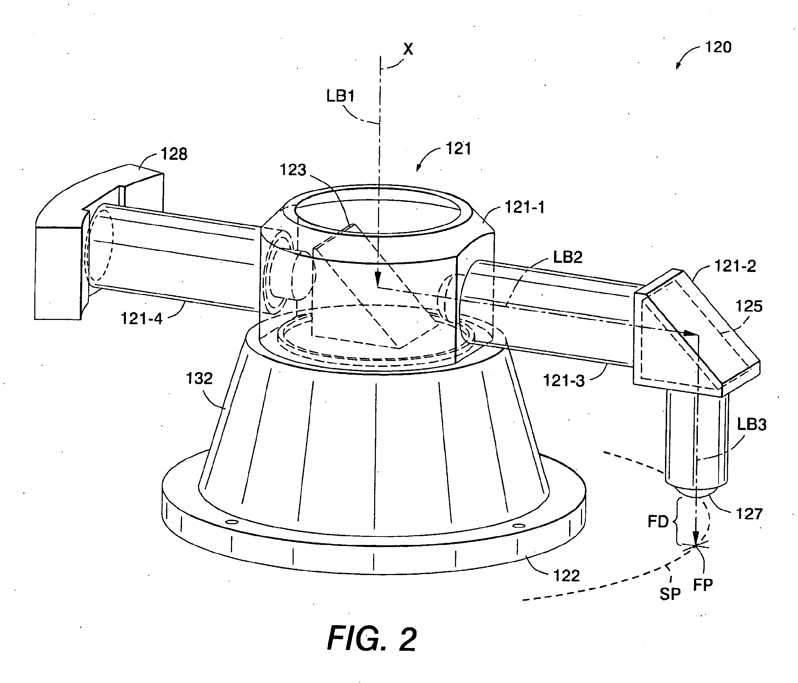

Referring to Fig. 1, in accordance with an aspect of the present invention, laser scanning mechanism 120 includes a rotating member 121 that is mounted on a stationary base 122 and is driven by a motor 132 to rotate around central axis X, and an optical system formed by first and second mirrors (optical elements) 123, 125, and an objective lens (focusing element) 127 that are fixedly mounted on rotating member 121 and arranged to redirect input laser beam pulses LB1 from central axis X to circular scan path SP. In particular, as indicated in Fig. 1 and in additional detail in Fig. 2, first mirror 123A is mounted on a generally cylindrical base (first) portion 121-1 of rotating member 121. Rotating member 121 also includes a head (second) portion 121-2 that supports second mirror 125, and a rigid, tubular central portion 121-3 that is connected between base portion 121-1 and head portion 121-2. First mirror 123 is arranged to reflect input laser beam pulses LB1 from central axis X to second mirror 125 along horizontal laser beam path LB2, which passes through a central axial region of tubular central portion 121-3. Second mirror 125 is disposed parallel to first mirror 123, and reflects laser beam pulses transmitted on horizontal path LB2 vertically downward to form output laser beam pulses LB3 that are directed parallel to central axis X. Output laser beam pulses LB3 pass through objective lens 127, which focuses the output laser beam pulses at a focal point FP that is a predetermined distance below objective lens 127. Rotation of rotating member 121 around central axis X causes focal point FP to travel along a circular scan path SP. Rotating member 121A further includes a second tubular portion 121-4 extending from base portion 121-1, and a counterweight 128 fixedly connected to an end of second tubular portion 121-4 and disposed such that base portion 121-1 is located between counterweight 128A and head portion 121-2. Counterweight 128 facilitates high speed rotation of orbiting objective 127, thus facilitating the high speed manufacture of photovoltaic devices.

In accordance with an aspect of the present invention, the output laser beam pulses LB3 transmitted by laser scanning apparatus 120 to wafers 211 are reliably focused on wafers 211 because the distance traveled by the light beam between laser device 110 and wafer 211 remains constant for all angular positions of rotating member 121. First, the vertical distances traveled by input light beam pulses LB1 (i.e., between laser device 110 and first mirror 123) and output light beam pulses LB3 (i.e., between second mirror 125 and the upper surface of a particular wafer 211) remains constant for any position of rotating member 121. In addition, the distance traveled by the light beam pulses along light beam path LB2 (i.e., between first mirror 123 and second mirror 125) remains constant when rotating member 121 is in any angular position relative to central axis X. In addition, objective lens 127 is disposed below second mirror 125 such that output light beam pulses LB3 pass therethrough, and is sized and positioned according to known techniques such that output laser beam portions LB3 are focused at a focal point FP that is a predetermined fixed distance FD below objective lens 127. Further, the planar upper surface of target wafers 211 are positioned at focal distance FD below objective lens 127. Therefore, the length of each laser beam portion LB1, LB2 and LB3 remains fixed, and the total distance between laser device 110 and focal point FP remains constant at any position along scan path SP. Thus, the laser beam pulses remain on-axis during each of light beam portions LB1, LB2 and LB3, and the focal point of each laser beam pulse coincides with the upper surface of wafers 211 when rotating member 121 is in any angular position. Thus, laser scanning mechanism 120 eliminates off-axis focusing errors and displacement aberrations that arise in conventional polygon ROS devices. Further, laser scanning mechanism 120 is relatively inexpensive to produce and relatively robust and reliable when compared with conventional ROS devices.

Referring again to Fig. 1, laser ablation apparatus 100 also includes a controller (e.g., a microprocessor and associated software) 130 for selectively controlling a motor 132, a stage moving motor 134, laser device 110, a stage loading device 170 and a stage unloading device 175. Processing stations 155 are circumferentially disposed around central axis X such that scan path SP simultaneously intersects multiple wafers 211. In one embodiment, each unprocessed wafer 211T1 is disposed on a corresponding stage 140 that is loaded into a corresponding station 155 by stage loading mechanism 170, and each processed wafer 211T2 is off-loaded from a corresponding station 155 by stage unloading mechanism 175. Each station 155 includes a mechanism (e.g., stage moving motor 134 and a radial slot 157) that is utilized to move a loaded stage 140 (and wafer 211) in a radial direction relative to central axis X such that upper surfaces of wafers 211 are systematically shifted across the circular scan path SP. In this manner, circular scan path SP simultaneously intersects multiple wafers 211 during each rotation of orbiting objective 127, thereby facilitating efficient use of laser device 110. For example, output laser beam pulses LB3 generated when orbiting objective 127 is disposed over each wafer 211 can be used ablate material from the surface of wafer 211. Further, by causing each station 155 to shift its associated wafer 211 in an associated radial direction (e.g., away from central axis X) after each scan pass, a two dimensional area of each wafer 211 is efficiently processed.

In accordance with an embodiment of the present invention, laser beam pulses are precisely timed using electronic registration devices 160, which are respectively disposed adjacent to each station 155. In one embodiment, electronic registration device 160 comprises a sensor that sends a detection signal to controller 130 each time head portion 121-2 passes over sensor 160. Controller 130 then utilizes the detection signal and information regarding the rotational speed of rotating member 120 to affect precise timing of the laser pulses such that wafers 211 are processed in the desired manner. Suitable devices for use as sensor 160 are known to those skilled in the art.

In accordance with a practical embodiment of the present invention described in detail below, laser ablation apparatus 100 is utilized to generate contact openings through a passivation layer formed on photovoltaic device wafers in the manner described below. In this context, because the laser (light) beam remains on-axis and reliably focused during all points along the scan path, laser scanning mechanism 120 provides robust and repeatable ablation performance. It is noted that the objective still has to focus the beam at an appropriate height from the surface, but the present invention makes this focusing issue more manageable, in comparison to conventional ROS devices.

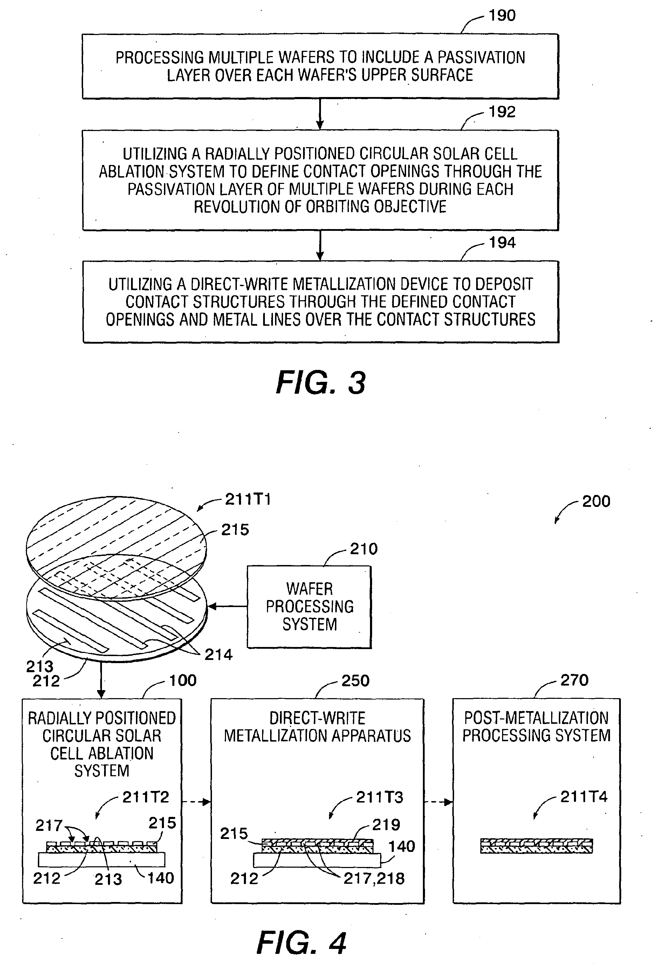

Figs. 3 and 4 depict the solar cell fabrication process associated with the present invention. Fig. 3 is a flow diagram indicating the basic processing steps utilizing laser scanning apparatus 100 (described above) to form contact openings in passivation layers formed on photovoltaic devices in accordance with an embodiment of the present invention. Fig. 4 is a simplified block diagram illustrating a system 200 for processing photovoltaic devices using laser ablation apparatus 100 in accordance with another embodiment of the present invention.

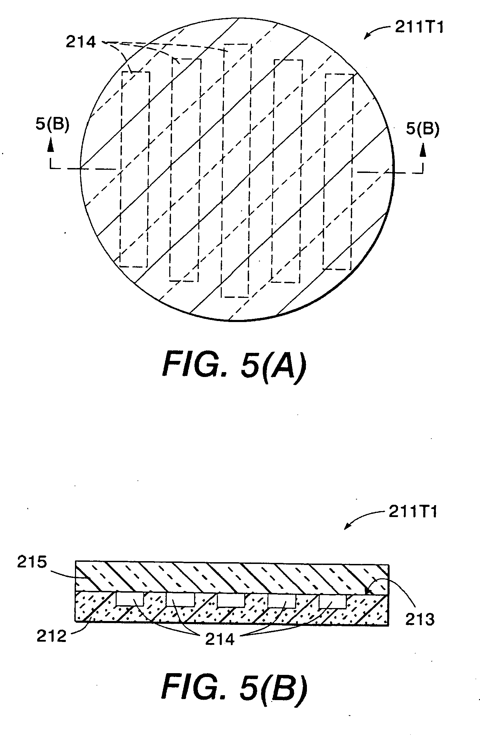

Referring to block 190 of Fig. 3 and to Figs. 4, 5(A) and 5(B), the method proposed herein begins by processing semiconductor (e.g., monocrystalline or multicrystalline silicon) substrates 212 using known photolithographic or other known techniques such that several parallel elongated doped diffusion regions 214 are disposed in an upper surface 213 thereof, and substrate 212 is further treated to include a blanket passivation (electrically insulating) layer 215 that is disposed on upper surface 213 over doped regions 214. As referred to herein, the photovoltaic device is generally as "wafer" or "device 211", and at each stage of the processing cycle is referenced with an appended suffix indicating the device's current processing stage (e.g., prior to the ablation process described below, device 211 is referenced as "device 211T1", with the suffix "T1" indicating a relatively early point in the process cycle). The operations used to provide device 211T1 with doped regions 214 and covering surface 213 with passivation layer 215 (block 190 in Fig. 3) are performed using well-known processing techniques, and thus the equipment utilized to produce device 211T1 is depicted generally in Fig. 4 as wafer processing system block 210.

After initial treatment, device 211T1 is transferred to laser ablation apparatus 100, which is utilized to define contact holes 217 through passivation layer 215 that expose corresponding portions of upper surface 213 of substrate 212 such that the contact holes are arranged in straight parallel rows over the doped diffusion regions (block 192). The ablation process is described in additional detail below.

After contact holes 217 are defined through passivation layer 215, partially processed wafers 211T2 are passed to a direct-write metallization apparatus 250 that is utilized to deposit contact structures 218 into contact holes 217, and to form metal interconnect lines 219 on passivation layer 215 such that each metal interconnect line 219 connects the contact structures 218 disposed over an associated doped diffusion region (block 194). As used herein, "direct-write metallization device" is defined as a device in which the metallization material is ejected, extruded, or otherwise deposited only onto the portions of the wafer where the metallization is needed (i.e., without requiring a subsequent mask and/or etching process to remove some of the metallization material). After the metallization process is completed, metallized device 211T3 is passed from direct-write metallization apparatus 250 to an optional post-metallization processing system 270 for subsequent processing to form the completed device 211T4.

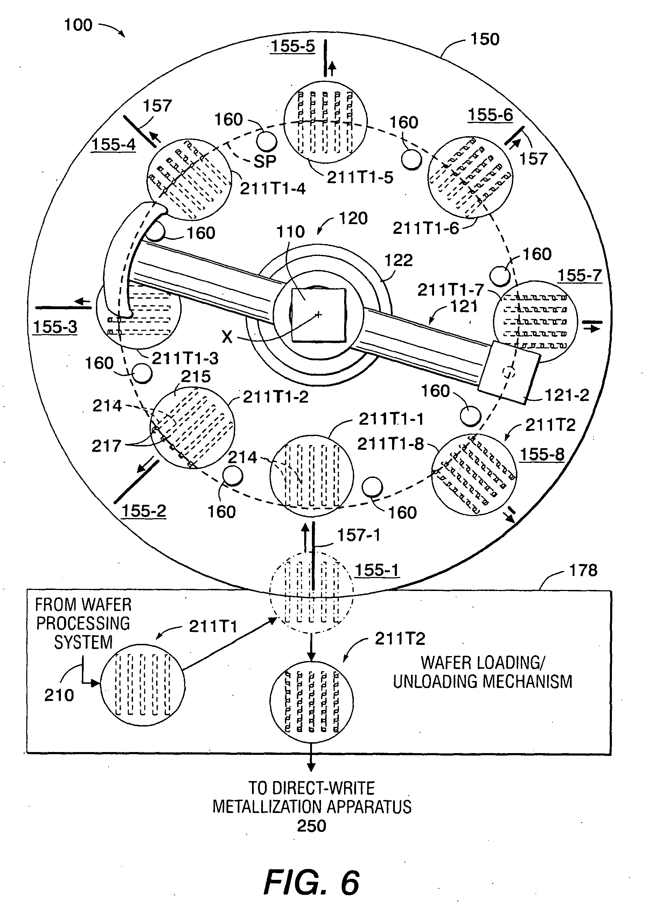

Fig. 6 is a simplified plan view depicting laser ablation apparatus 100 during operation. Stages 140 and structures associated with platforms 150 are omitted from Fig. 6 for illustrative purposes. Rotating member 121 of laser scanning mechanism 120 rotates around central axis X in the manner described above such that output laser beam pulses (not shown) transmitted from head portion 121-2 are produced at selected points along circular scan path SP, and are directed downward (i.e., into the sheet). In the disclosed embodiment, a combination wafer loading/unloading mechanism (robot) 178 is used to load unprocessed wafers 211T1A and to off-load processed wafers 211T2. In a specific embodiment, robot 178 is maintained in a fixed position, and circular platform 150 is rotated around central axis X to facilitate the wafer loading/unloading process with respect to each of the eight circumferentially disposed stations 155-1 to 155-8. In an alternative embodiment, circular platform 150 is maintained in a fixed position, and robot 178 is rotated around a peripheral edge of circular platform 150 to facilitate the wafer loading/unloading process.

As indicated at the bottom of Fig. 6, the contact hole forming (or other micro-machining) process performed by laser ablation apparatus 100 begins when robot 178 loads an unprocessed wafer 211T1 received from wafer processing system 210 (see Fig. 4) onto a vacant station 155-1. Stations 155-2 to 155-8 are occupied by wafers 211T1-2 to 211T1-8, respectively, which are depicted in gradually degrees of processing, with wafer 211T1-8 depicting the final processing stage. In a preferred embodiment, the unprocessed wafer is positioned in a relatively close proximity to central axis X at the beginning of the processing cycle, and is gradually shifted away from central axis X as the micro-machining process progresses. For example, wafer 211T1-1 is depicted in a fully inserted position in station 155-1 before processing is initiated. After each subsequent scanning pass, wafer 211T-1 will be systematically shifted away from central axis X along radial slot 157-1 by a predetermined radial distance. For example, station 155-2 illustrates a wafer 211T1-2 after an initial processing pass in which a first row of contact openings 217 are formed in passivation layer 215. As indicated in station 155-3, after the first row of contact openings is formed, wafer 211T1-3 is incrementally shifted outward, and a second row of contact openings is formed during a next sequential scanning pass. In this manner the completed wafer 211T2 are conveniently removed with minimal delay.

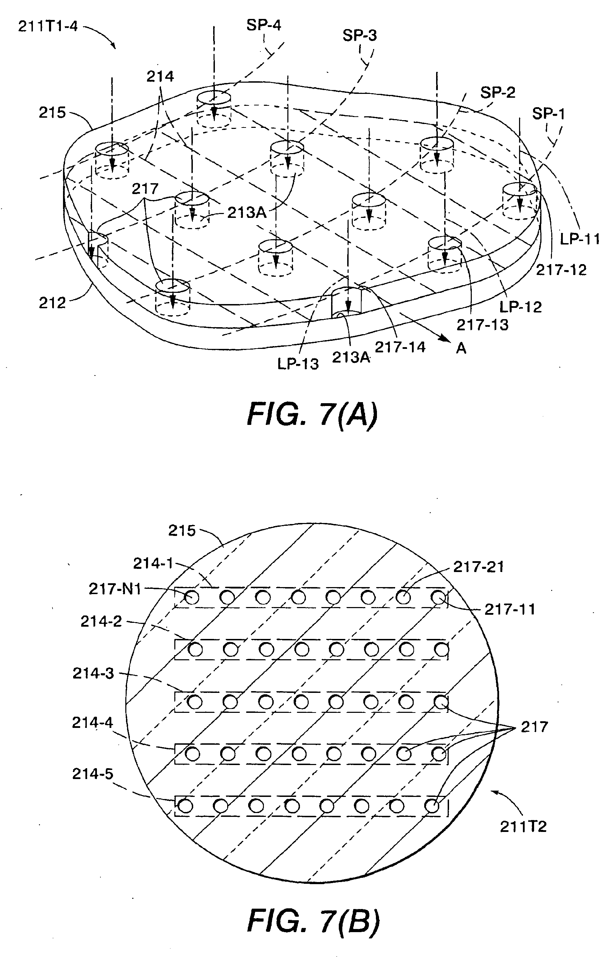

Fig. 7(A) shows a portion of wafer 211T1-4 and the laser pulses generated during sequential scan passes SP-1 to SP-4 that ablate (remove) associated portions of passivation layer 215 to form contact openings 217, thereby exposing surface portions 213A of substrate 212 over doped regions 214 without the need for cleaning or other processing prior to metallization. For example, laser pulses LP-11 to LP-13 are generated during scan pass SP-1 to form contact openings 217-12, 217-13 and 217-14, respectively. An advantage of using laser ablation over other contact opening methods such as chemical etching, is that substrate 212 need not be rinsed and dried after the ablation is performed. Avoidance of rinsing and drying steps enables the rapid and successive processing of the contact opening following by the metallization. The avoidance of rinsing and/or other post-ablation treatment is essential for performing metallization immediately after the ablation process is completed. In particular, rinsing and drying after ablation/etching would generally preclude the precise machine tooled registration of the subsequent metallization. Rinsing and drying also contribute to wafer breakage.

Referring again to Fig. 6, wafers 211T1-1 to 211T1-7 depict systematic shifting and scanning passes, which ultimately forms a completed two dimensional processed area such as that depicted by wafer 211T2 (station 155-8). In accordance with another aspect of the present invention, electronic registration devices 160 are used in conjunction with stage moving motors 134 (see Fig. 1) to compensate for the curved scan path SP, thus producing straight rows/columns of contact openings that are respectively aligned with doped regions 214 of each wafer 211T1-1 to 211T7 and completed wafer 211T2 . To produce this alignment, as shown at the bottom of Fig. 6, wafer 211T1-1 is loaded into station 155-1 such that elongated diffusion regions 214 are parallel to the radial wafer processing direction (i.e., parallel to the associated radial slot 157-1, and substantially perpendicular to circular scan path SP). Electronic registration devices 160 are then utilized during a first scan pass to generate contact openings 217 over doped regions 214, as indicated by wafer 211T1-2 (station 155-2). In one embodiment, electronic registration devices 160 transmit detection signals indicating the precise position of head portion 121-2 as it approaches each wafer, and the laser control circuitry utilizes the detection signals to initiate a precisely timed sequence of laser beam pulses that produce contact openings 217 aligned with doped regions 214. Because each wafer is shifted in the radial direction (i.e., parallel to elongated doped regions 214) after each scan pass, the process of detecting head 121-2 and initiating the precisely timed laser beam pulse sequence can be repeated for each row of contact openings 217. As indicated, this process of incrementally moving stage 140A and precisely actuating the laser device to generate rows of contact openings is repeated until a final row of contact holes is generated. At this point the ablation process is completed, and device 211T2 has the desired two dimensional pattern of contact openings. As indicated in Fig. 7(B), the two dimensional pattern defined by contact openings 217 includes straight columns that extend along corresponding doped regions 214-1 to 214-5. For example, contact hole 217-11 formed during a first scan pass is aligned with contact hole 217-21 formed during a second scan pass and contact hole 217-N1 formed during an Nth scan pass.

Upon completion of the micro-machining process, completed wafer 211T2 is removed from its associated station by robot 178, which then transmits completed wafer 211T2 to direct-write metallization apparatus 250 (see Fig. 4).

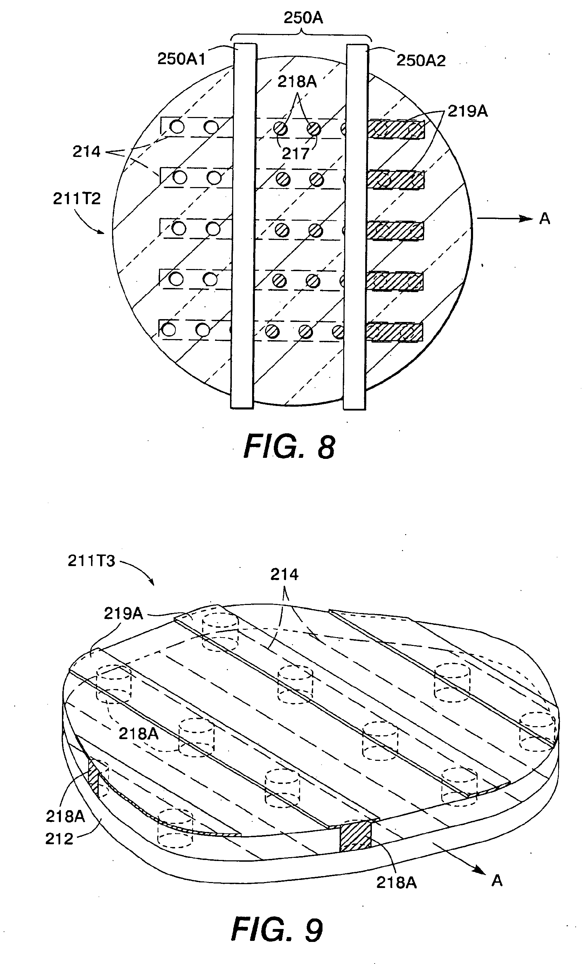

Fig. 8 depicts a simplified direct-write metallization device 250A according to another aspect of the present invention. As used herein, "direct-write metallization device" is defined as a device in which the metallization material is ejected, extruded, or otherwise deposited only onto the portions of the substrate where the metallization is needed (i.e., without requiring a subsequent mask and/or etching process to remove some of the metallization material). In the embodiment depicted in Fig. 8, direct-write metallization device 250A includes a first ejection head 250A1 that is used to deposit a contact (metallization) portion 218A into each opening 217 of device 211T2, and a second ejection head 250A2 immediately downstream from first ejection head 250A1 that is used to form current-carrying conductive lines 219A that extend over associated doped diffusion regions 214. Additional details related to direct-write metallization device 250A are disclosed in co-owned U.S. Published Patent Application US 2007/0169806 A1, entitled "SOLAR CELL PRODUCTION USING NON-CONTACT PATTERNING AND DIRECT-WRITE METALLIZATION".

In accordance with another aspect of the present invention, as indicated in Fig. 8, device 211T2 is passed under direct-write metallization device 250A in the moving direction A (i.e., in a direction parallel to doped regions 214). Because the present invention facilitates the non-contact formation of contact holes in a straight line over doped regions 214, immediate execution of the metallization process is greatly simplified, thus reducing overall manufacturing costs.

As indicated in Fig. 9, contact portions 218A facilitate electrical connection of current-carrying conductive lines 219A to the diffusion regions 214 formed in substrate 212. Upon completion of the metallization process by direct-write metallization apparatus 250A, devices 211T3 are transported to optional post metallization processing system 270 (Fig. 4).

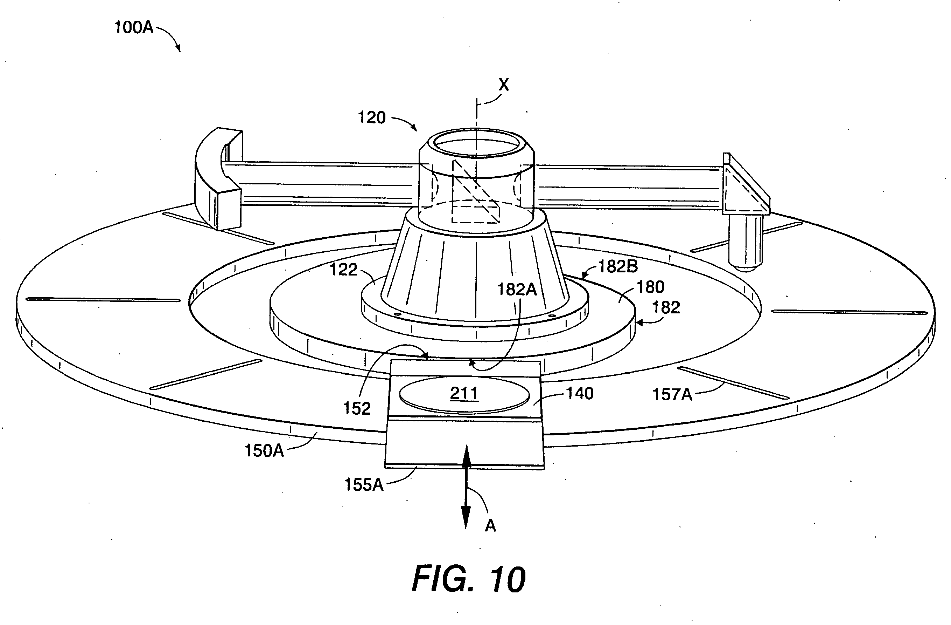

Fig. 10 is a perspective view showing a multiple station laser ablation apparatus 100A according to an alternative embodiment of the present invention. Multiple station laser ablation apparatus 100A differs from the embodiments described above in that it includes positioning cam 180 and movable stations 155A. Positioning cam 180 is around central axis X such that cam surface 182 extends around stationary base 122 of laser scanning mechanism 120. Movable stations 155A (one shown) are disposed to move in a radial direction A relative to circular platform 150A (i.e., each movable station 155A is constrained to slide along a corresponding guide slot 157A), and include a cam follower (front surface) 152 that contacts cam surface 182. Each station 155A supports a wafer 211/stage 140 such that wafer 211 remains fixed relative to its associated movable station 155A, whereby radial movement of movable stations 155A causes a corresponding movement of wafer 211 relative to the scan path (not shown). In one embodiment, apparatus 100A includes a mechanism (not shown) for rotating positioning cam 180 around central axis X, and circular platform 150A remains stationary relative to positioning cam 180. In an alternative embodiment, positioning cam 180 remains stationary and circular platform 150A is rotated around central axis X. In either embodiment the radial position of each movable station 155A is determined by the point along cam surface 182 that contacts the cam follower 152 of that movable station. For example, Fig. 10 shows cam follower 152 of station 155A contacting cam surface region 182A, which is relatively far from central axis X, whereby movable station 155A and wafer 211 are positioned relatively far from central axis X. In contrast, when movable station 155A contacts cam surface region 182B, movable station 155A would be positioned relatively close to central axis X. By controlling the position of each movable station in this manner, the gradual processing arrangement shown in Fig. 6 is achieved without expensive stage positioning mechanisms.

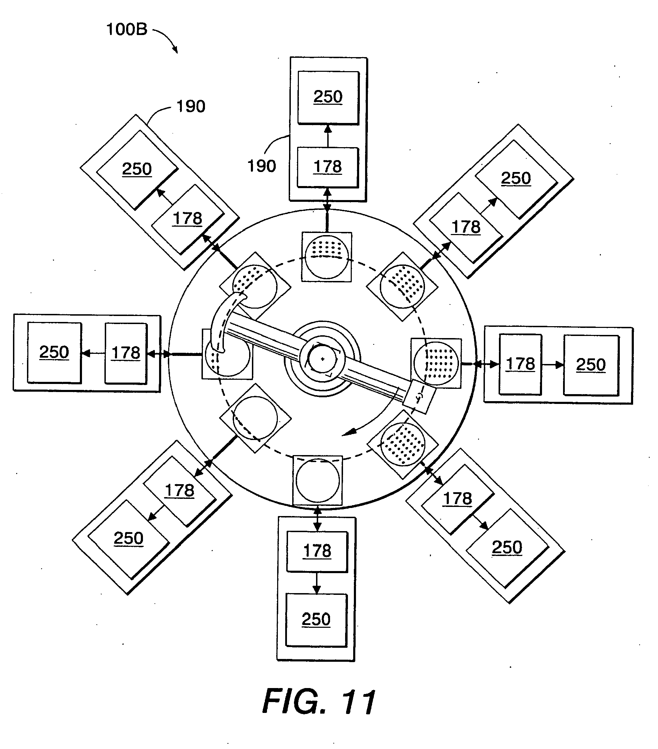

Fig. 11 is a plan view showing a multiple station laser ablation apparatus 100B according to another alternative embodiment of the present invention. Multiple station laser ablation apparatus 100B differs from the embodiments described above in that each station is supported by a processing apparatus 190 that includes both a loader/unloader robot 178 and a direct-write metallization apparatus 250 (both described above). By providing each station with both a processing apparatus 190 and a loader/unloader robot 178, multiple station laser ablation apparatus 100B facilitates high volume production of , for example, photovoltaic devices.

Although the present invention has been described with respect to certain specific embodiments, it will be clear to those skilled in the art that the inventive features of the present invention are applicable to other embodiments as well, all of which are intended to fall within the scope of the present invention. For example, although the invention is described with specific reference to solar cells having an integrated back contact (IBC) cell geometry (i.e., including elongated doped regions 214), the present invention may also be utilized to produce other solar cell types.

## Claims

1. A multi-station laser ablation apparatus (100) for simultaneously micro-machining a plurality of target objects (211), wherein the system comprises:
a laser device (110) for selectively generating a plurality of input laser beam pulses along a central axis (x); and
a laser scanning mechanism (120),
**characterized in that**
the laser scanning mechanism (120) including a rotating member (121) disposed to rotate around the central axis (x), and an optical system that is fixedly mounted on the rotating member (121) and arranged such that the plurality of input laser beam pulses are redirected from the central axis (x) to a circular scan path (SP) defined around the central axis (x), whereby output laser beam pulses are selectively produced on the circular scan path (SP), and
a plurality of stations (155) circumferentially disposed around the central axis (x), each station (155) including means (134) for moving a corresponding one of the plurality of target objects (211) in a corresponding radial direction relative to the central axis (x) such that said corresponding target object (211) intersects a corresponding portion of the circular scan path (SP).

2. The multi-station laser ablation apparatus of Claim 1,
wherein the rotating member (121) of the laser scanning mechanism (120) includes a first portion (121-1) disposed to rotate around the central axis, and a second portion disposed away from the central axis (x),
wherein the optical system comprises:
a first optical element (123) fixedly disposed on the first portion (121-1) of the rotating member (121) such that the central axis (x) intersects a portion of the first optical element (123),
a second optical element (125) disposed on the second portion (121-2) of the rotating member (121), and
a focusing element (127) disposed on the rotating member (121) in fixed relation to the second optical element (125), and
wherein the first and second optical elements (123,125)are arranged such that the first optical element (123) redirects the plurality of input laser beam pulses from the central axis (x) to the second optical element (125), wherein the second optical element (125) redirects the laser beam pulse received from the first optical element (123) through the focusing element (127) toward the circular scan path (SP), and wherein the focusing element (127) is disposed to focus the output laser beam pulses such that a focal point of each output laser beam pulse coincides with the circular scan path (SP).

3. The multi-station laser ablation apparatus of Claim 2,
wherein the first and second optical elements (123, 125) comprise mirrors having respective flat reflective surfaces that are parallel, and
wherein the focusing element (127) comprises an objective lens disposed between the second mirror (125) and the focal point.

4. The multi-station laser ablation apparatus of Claim 3,
wherein the first mirror (123) is disposed at a fixed distance from the second mirror (125), and
wherein the objective lens (127) is disposed at a fixed distance from the second mirror (125).

5. The multi-station laser ablation apparatus of Claim 1,
wherein each of the plurality of target objects (211) comprises a semiconductor substrate including doped regions diffused into a surface thereof and a passivation layer formed thereon, and
wherein said means (134) for moving said corresponding photovoltaic device in said corresponding radial direction comprises means for maintaining said corresponding target object (211) such that ablated regions defined in the passivation layer by said output laser beam pulses are substantially parallel to said corresponding radial direction.

6. The multi-station laser ablation apparatus of Claim 5, further comprising means (130) for controlling the laser device to selectively generate the plurality of input laser beam pulses when the rotating member (121) of the laser scanning mechanism (120) is positioned over a predetermined portion of the passivation layer of an associated one of said semiconductor substrates.

7. The multi-station laser ablation apparatus of Claim 6, wherein said means (130) for controlling the laser device (110) comprises an electronic registration device (160) disposed adjacent to at least one of said plurality of stations (155).

8. The multi-station laser ablation apparatus of Claim 1, wherein the laser device is a femto-second laser device.

9. The multi-station laser ablation apparatus of Claim 1, further comprising a positioning cam (180) disposed around the central axis (x) for controlling associated positions of each of the plurality of target objects (211) in said corresponding radial direction.

10. A system for producing a plurality of photovoltaic devices, each photovoltaic device including a semiconductor substrate having a passivation layer disposed on a surface thereof, wherein the system comprises the multi-station laser ablation apparatus according to claim 1.

## Patentansprüche

1. Mehrstationen-Laserablations-Vorrichtung (100) für gleichzeitige Mikrobearbeitung einer Vielzahl von Zielobjekten (211), wobei das System umfasst:
eine Lasereinrichtung (110) zum selektiven Erzeugen einer Vielzahl von Eingangs-Laserstrahlimpulsen entlang einer Mittelachse (x); und
einen Laserabtastmechanismus (120),
**dadurch gekennzeichnet, dass**
der Laserabtastmechanismus (120) ein Drehelement (121), das so angeordnet ist, dass es sich um die Mittelachse (x) herum dreht, und ein optisches System enthält, das an dem Drehelement (121) fest angebracht und so eingerichtet ist, dass die Vielzahl von Eingangs-Laserstrahlimpulsen von der Mittelachse (x) auf einen kreisförmigen Abtastweg (SP) geleitet werden, der um die Mittelachse (x) herum definiert ist, so dass Ausgangs-Laserstrahlimpulse selektiv auf dem kreisförmigen Abtastweg (SP) erzeugt werden, und
eine Vielzahl von Stationen (155), die in Umfangsrichtung um die Mittelachse (x) herum angeordnet sind, wobei jede Station (155) eine Einrichtung (134) enthält, mit der ein entsprechendes der Vielzahl von Zielobjekten (211) so in einer entsprechenden radialen Richtung relativ zu der Mittelachse (x) bewegt wird, dass das entsprechende Zielobjekt (211) einen entsprechenden Abschnitt des kreisförmigen Abtastweges (SP) schneidet.

2. Mehrstationen-Laserablationsvorrichtung nach Anspruch 1,
wobei das Drehelement (121) des Laserabtastmechanismus (120) einen ersten Abschnitt (121-1), der so angeordnet ist, dass er sich die Mittelachse herum dreht, und einen zweiten Abschnitt enthält, der von der Mittelachse (x) entfernt angeordnet ist, wobei das optische System umfasst:
ein erstes optisches Element (123), das an dem ersten Abschnitt (121-1) des Drehelementes (121) fest so angeordnet ist, dass die Mittelachse (x) einen Abschnitt des ersten optischen Elementes (123) schneidet,
ein zweites optisches Element (125), das an dem zweiten Abschnitt (121-2) des Drehelementes (121) angeordnet ist, und
ein Fokussierelement (127), das an dem Drehelement (121) in fester Beziehung zu dem zweiten optischen Element (125) angeordnet ist, und
wobei das erste und das zweite optische Element (123, 125) so eingerichtet sind, dass das erste optische Element (123) die Vielzahl von Eingangs-Laserstrahlimpulsen von der Mittelachse (x) zu dem zweiten optischen Element (125) umleitet, und das zweite optische Element (125) den von dem ersten optischen Element (123) empfangenen Laserstrahlimpuls über das Fokussierelement (127) in Richtung des kreisförmigen Abtastweges (SP) umleitet, und das Fokussierelement (127) so angeordnet ist, dass es die Ausgangs-Laserstrahlimpulse so fokussiert, dass ein Brennpunkt jedes Ausgangs-Laserstrahlimpulses mit dem kreisförmigen Abtastweg (SP) zusammenfällt.

3. Mehrstationen-Laserablationsvorrichtung nach Anspruch 2,
wobei das erste und das zweite optische Element (123, 125) Spiegel umfassen, die jeweilige plane reflektierende Flächen aufweisen, die parallel sind, und
das Fokussierelement (127) eine Objektivlinse umfasst, die zwischen dem zweiten Spiegel (125) und dem Brennpunkt angeordnet ist.

4. Mehrstationen-Laserablationsvorrichtung nach Anspruch 3,
wobei der erste Spiegel (123) in einem festen Abstand zu dem zweiten Spiegel (125) angeordnet ist, und
die Objektivlinse (127) in einem festen Abstand zu dem zweiten Spiegel (125) angeordnet ist.

5. Mehrstationen-Laserablationsvorrichtung nach Anspruch 1,
wobei jedes der Vielzahl von Zielobjekten (211) ein Halbleitersubstrat umfasst, das dotierte Bereiche, die in seine Oberfläche diffundiert sind, sowie eine darauf ausgebildete Passivierungsschicht enthält, und
die Einrichtung (134), mit der die entsprechende Photovoltaikeinrichtung in der entsprechenden radialen Richtung bewegt wird, eine Einrichtung umfasst, mit der
das entsprechende Zielobjekt (211) so gehalten wird, dass abgetragene Bereiche, die durch die Ausgangs-Laserstrahlimpulse in der Passivierungsschicht ausgebildet werden, im Wesentlichen parallel zu der entsprechenden radialen Richtung sind.

6. Mehrstationen-Laserablationsvorrichtung nach Anspruch 5, die des Weiteren eine Einrichtung (130) umfasst, mit der die Lasereinrichtung so gesteuert wird, dass selektiv die Vielzahl von Eingangs-Laserstrahlimpulsen erzeugt wird, wenn das Drehelement (121) des Laserabtastmechanismus (120) über einem vorgegebenen Abschnitt der Passivierungsschicht eines dazugehörigen der Halbleitersubstrate positioniert ist.

7. Mehrstationen-Laserablationsvorrichtung nach Anspruch 6, wobei die Einrichtung (130) zum Steuern der Lasereinrichtung (110) eine elektronische Ausrichteinrichtung (160) umfasst, die nahe an wenigstens eine der Vielzahl von Stationen (155) angrenzend angeordnet ist.

8. Mehrstationen-Laserablationsvorrichtung nach Anspruch 1, wobei die Lasereinrichtung eine Femtosekunden-Lasereinrichtung ist.

9. Mehrstationen-Laserablationsvorrichtung nach Anspruch 1, die des Weiteren einen Positioniernocken (180) umfasst, der um die Mittelachse (x) herum angeordnet ist, um mit jedem der Vielzahl von Zielobjekten (211) zusammenhängende Positionen in der entsprechenden radialen Richtung zu steuern.

10. System zum Erzeugen einer Vielzahl von Photovoltaikeinrichtungen, wobei jede Photovoltaikeinrichtung ein Halbleitersubstrat enthält, das eine Passivierungsschicht aufweist, die an einer Oberfläche desselben angeordnet ist, und das System die Mehrstationen-Laserablationsvorrichtung nach Anspruch 1 umfasst.

## Revendications

1. Appareil (100) d'ablation laser multi-stations pour le micro-usinage simultané d'une pluralité d'objets cibles (211), où le système comprend:
un dispositif (110) laser pour générer au choix une pluralité d'impulsions de faisceaux laser d'entrée le long d'un axe central (x); et
un mécanisme (120) de balayage laser,
**caractérisé en ce que**
le mécanisme (120) de balayage laser comportant un organe rotatif (121) disposé pour se mettre en rotation autour de l'axe central (x), et un système optique qui est monté fixe sur l'organe rotatif (121) et agencé de sorte que la pluralité d'impulsions de faisceaux laser d'entrée soient redirigées depuis l'axe central (x) vers un chemin de balayage circulaire (SP) défini autour de l'axe central (x), moyennant quoi des impulsions de faisceaux laser de sortie sont produites au choix sur le chemin de balayage circulaire (SP), et
une pluralité de stations (155) disposées de manière circonférentielle autour de l'axe central (x), chaque station (155) comportant un moyen (134) destiné à déplacer un objet correspondant parmi la pluralité d'objets cibles (211) dans une direction radiale correspondante par rapport à l'axe central (x) de sorte que ledit objet cible correspondant (211) croise une partie correspondante du chemin de balayage circulaire (SP).

2. Appareil (100) d'ablation laser multi-stations de la revendication 1,
dans lequel l'organe rotatif (121) du mécanisme (120) de balayage laser comporte une première partie (121-1) disposée pour se mettre en rotation autour de l'axe central, et une deuxième partie disposée loin du centre axial (x),
où le système optique comprend:
un premier élément optique (123) disposé fixe sur la première partie (121-1) de l'organe rotatif (121) de sorte que l'axe central (x) croise une partie du premier élément optique (1.23),
un deuxième élément optique (125) disposé sur la deuxième partie (121-2) de l'organe rotatif (121), et
un élément de focalisation (127) disposé sur l'organe rotatif (121) dans une relation fixe par rapport au deuxième élément optique (125), et
où les premier et deuxième éléments optiques (123, 125) sont agencés de sorte que le premier élément optique (123) redirige la pluralité d'impulsions de faisceaux laser d'entrée de l'axe central (x) au deuxième élément optique (125), où le deuxième élément optique (125) redirige l'impulsion de faisceau laser reçue du premier élément optique (123) à travers l'élément de focalisation (127) vers Le chemin de balayage circulaire (SP), et où l'élément (127) de localisation est disposé pour focaliser les impulsions de faisceaux laser de sortie de sorte qu'un point focal de chaque impulsion de faisceau laser de sortie coïncide avec le chemin de balayage circulaire (SP).

3. Appareil (100) d'ablation laser multi-stations de la revendication 2,
dans Lequel les premier et deuxième éléments optiques (123, 1.25) comprennent des miroirs ayant des surfaces réfléchissantes plastes respectives qui sont parallèles, et
où l'élément de focalisation (127) comprend une lentille de focalisation disposée entre le deuxième miroir (125) et le point focal.

4. Appareil (100) d'ablation par laser multi-stations de la revendication 3,
dans lequel le premier miroir (123) est disposé à une distance fixe du deuxième miroir (125), et
où la lentille de focalisation (127) est disposée à une distance fixe du deuxième miroir (125).

5. Appareil (100) d'ablation laser multi-stations de la revendication 1,
dans Lequel chacun de la pluralité d'objets cibles (211) comprend un substrat semi-conducteur comportant des régions dopées diffusées dans une surface correspondante et une couche de passivation formée par-dessus, et
où Ledit moyen (134) destiné à déplacer ledit dispositif photovoltaïque correspondant dans ladite direction radiale correspondante comprend un moyen destiné à maintenir ledit objet cible correspondant (211) de sorte que des régions ablatées définies dans la couche de passivation par Lesdites impulsions de faisceaux laser de sortie soient essentiellement parallèles à ladite direction radiale correspondant.

6. Appareil (100) d'ablation laser multi-stations de la revendication 5, comprenant en outre un moyen (130) destiné à commander le dispositif laser pour générer au choix La pluralité d'impulsions de faisceaux laser d'entrée lorsque l'organe rotatif (121) du mécanisme (120) de balayage laser est positionné sur une partie prédéterminée de la couche de passivation d'un substrat associé parmi lesdits substrats semi-conducteurs.

7. Appareil (100) d'ablation laser multi-stations de la revendication 6, dans lequel ledit moyen (130) destiné à commander le dispositif (110) laser comprend un dispositif d'enregistrement électronique (160) disposé de manière adjacente à au moins l'une de ladite pluralité de stations (155).

8. Appareil (100) d'ablation laser multi-stations de la revendication 1, dans lequel le dispositif laser est un dispositif laser femtoseconde.

9. Appareil (100) d'ablation laser multi-stations de la revendication 1, comprenant en outre une came de positionnement (180) disposée autour de l'axe central (x) pour commander des positions associées de chacun de la pluralité d'objets cibles (211) dans ladite direction radiale correspondante.

10. Système pour produire une pluralité de dispositifs photovoltaiques, chaque dispositif photovoltaïque comportant un substrat semi-conducteur ayant une couche de passivation disposée sur une surface correspondante, où le système comprend l'appareil d'ablation laser multi-stations selon la revendication 1.
